# EUROPÄISCHE PATENTSCHRIFT

(11) **EP 2 398 147 B1**
(45) Veröffentlichungstag und Bekanntmachung des Hinweises auf die Patenterteilung: **18.09.2019**
(21) Anmeldenummer: 11162816.0
(22) Anmeldetag: 18.04.2011
(51) Int. Cl.: H03K 19/173, H03K 19/177, H03K 17/56, H03K 17/567, H03K 17/687, H03F 3/08, H01H 85/54, H01H 85/041

(54) **Verfahren sowie elektrische Schaltung zum Betreiben eines elektrischen Leistungshalbleiter-Bauelements**
Method and electrical switch for operating an electrical power semiconductor element
Procédé et circuit électrique pour le fonctionnement d'un semi-conducteur de puissance électrique

(30) Priorität: 16.06.2010 DE 102010024038
(43) Veröffentlichungstag der Anmeldung: 21.12.2011
(73) Patentinhaber: GE Energy Power Conversion Technology Limited, Rugby Warwickshire CV21 1BU (GB)
(72) Erfinder: Oesterle, Robert, 12555 Berlin (DE); Keller, Christian, Dr., 14169 Berlin (DE)
(74) Vertreter: Serjeants LLP

(56) Entgegenhaltungen:
- EP-A2- 0 620 645
- DE-A1- 10 223 496
- US-A1- 2008 265 935
- US-B1- 6 337 799

## Beschreibung

Die Erfindung betrifft ein Verfahren sowie eine elektrische Schaltung zum Betreiben eines elektrischen Leistungshalbleiter-Bauelements.

Es ist bekannt, ein Leistungshalbleiter-Bauelement mit Hilfe einer Endstufe anzusteuern. Ebenfalls ist es bekannt, dass die Endstufe eine programmierbare Logik aufweist, so dass die Art und Weise der Ansteuerung des Leistungshalbleiter-Bauelements durch eine entsprechende Programmierung vorgegeben werden kann. Dabei kann es im Verlauf des Gebrauchs der Endstufe erforderlich sein, die Programmierung der Logik zu verändern. Dies kann beispielsweise dadurch erreicht werden, dass ein Servicetechniker die Logik manuell mit einem Programmier-Werkzeug verbindet, zum Beispiel mit einem Notebook, um dann ein Programm-Update von dem Notebook auf die programmierbare Logik zu übertragen und damit die Logik neu zu programmieren. Dieser Vorgang muss am Ort des Leistungshalbleiter-Bauelements bzw. der Endstufe vorgenommen werden. Bei einer elektrischen Stromrichterschaltung, die eine Vielzahl von Leistungshalbleiter-Bauelementen und dazugehörige Endstufen aufweisen kann, ist der Aufwand für das vorstehend erläuterte Vorgehen ersichtlich sehr hoch.

Solche programmierbaren Schaltungen nach dem Stand der Technik sind beispielsweise aus US 6,337,799 B1 und US 2008/265935 A1 bekannt.

Aufgabe der Erfindung ist es, ein Verfahren sowie eine elektrische Schaltung zum Betreiben eines elektrischen Leistungshalbleiter-Bauelements zu schaffen, mit denen beispielsweise ein Programm-Update mit weniger Aufwand auf die programmierbare Logik übertragen werden kann.

Diese Aufgabe wird durch ein Verfahren nach dem Anspruch 1 sowie durch eine elektrische Schaltung nach dem Anspruch 8 gelöst. Bei der Erfindung ist dem Leistungshalbleiter-Bauelement eine Endstufe mit einer programmierbaren Logik zugeordnet. Der Endstufe werden Ansteuersignale für das Leistungshalbleiter-Bauelement gesendet und das Leistungshalbleiter-Bauelement wird von der Endstufe in Abhängigkeit von den Ansteuersignalen beeinflusst. Die Art und Weise der Beeinflussung des Leistungshalbleiter-Bauelements ist dabei durch die Programmierung der Logik festlegt. Der Endstufe werden Programmiersignale gesendet, die von einem Prozessor der Endstufe verarbeitet werden. Die Programmierung der Logik wird von dem Prozessor in Abhängigkeit von den Programmiersignalen verändert.

Dieses Vorgehen bringt den Vorteil mit sich, dass ein Programm-Update gemäß der Erfindung dadurch auf die programmierbare Logik der Endstufe übertragen werden kann,
dass die entsprechenden Programmiersignale an die Endstufe übertragen werden und der dortige Prozessor dann die Logik entsprechend den Programmiersignalen neu programmiert oder umprogrammiert. Es ist somit nicht mehr erforderlich, dass der Servicetechniker unmittelbar am Ort des Leistungshalbleiter-Bauelements bzw. der Endstufe tätig wird. Stattdessen ist es ausreichend, dass die Programmiersignale auf irgendeine Weise an die Endstufe gesendet werden. Dort werden die Programmiersignale automatisch zur Neu- oder Um-Programmierung der Logik weiterverarbeitet.

Bei einer vorteilhaften Weiterbildung der Erfindung wird die Logik von dem Prozessor in einen Programmierbetrieb umgeschaltet, in dem das Leistungshalbleiter-Bauelement nicht mehr in Abhängigkeit von den Ansteuersignalen beeinflusst wird. Damit wird vermieden, dass während der Programmierung der Logik irgendwelche Fehlfunktionen der Endstufe auftreten.

Eine weitere vorteilhafte Ausgestaltung der Erfindung besteht darin, dass die Programmiersignale von einer Steuerung versendet werden. Damit ist es möglich, von einer zentralen Steuerung mehrere Endstufen von unterschiedlichen Leistungshalbleiter-Bauelementen auf die erfindungsgemäße Weise neu zu programmieren. Dies ist gleichbedeutend damit, dass der Servicetechniker nicht mehr jeder Endstufe einzeln ein Programm-Update aufspielen muss, sondern es ist stattdessen möglich, dass die zentrale Steuerung die neue Programmierung automatisch an alle Endstufen überträgt. Ersichtlich wird hierdurch eine weitere wesentliche Vereinfachung erzielt.

Die Vorteile der Erfindung kommen insbesondere bei einer Stromrichterschaltung mit einer Vielzahl von Leistungshalbleiter-Bauelementen mit zugehörigen Endstufen zur Geltung. In diesem Fall erlaubt es die Erfindung, dass nur der Steuerung mitgeteilt werden muss, welche Programmiersignale an die Vielzahl der Endstufen übertragen werden soll, und dass dann die Steuerung diese Programmiersignale automatisch an alle Endstufen überträgt, ohne dass hierzu ein weiterer manueller Aufwand erforderlich ist.

Besonders vorteilhaft ist es, wenn die Steuerung der Stromrichterschaltung zur Fernwartung geeignet ist. In diesem Fall ist es nicht mehr notwendig, dass sich der Servicetechniker an den Ort der Stromrichterschaltung begibt. Stattdessen können die Programmiersignale per Fernwartung an die Steuerung übertragen werden, um dann von der Steuerung auf die Endstufen überspielt zu werden. Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei wird der Gegenstand der Erfindung durch den Schutzumfang der Ansprüche definiert.
Figur 1 zeigt ein schematisches Blockschaltbild einer erfindungsgemäßen elektrischen Schaltung zum Betreiben eines elektrischen Leistungshalbleiter-Bauelements und
Figur 2 zeigt ein schematisches Blockschaltbild einer erfindungsgemäßen Endstufe der elektrischen Schaltung der Figur 1.

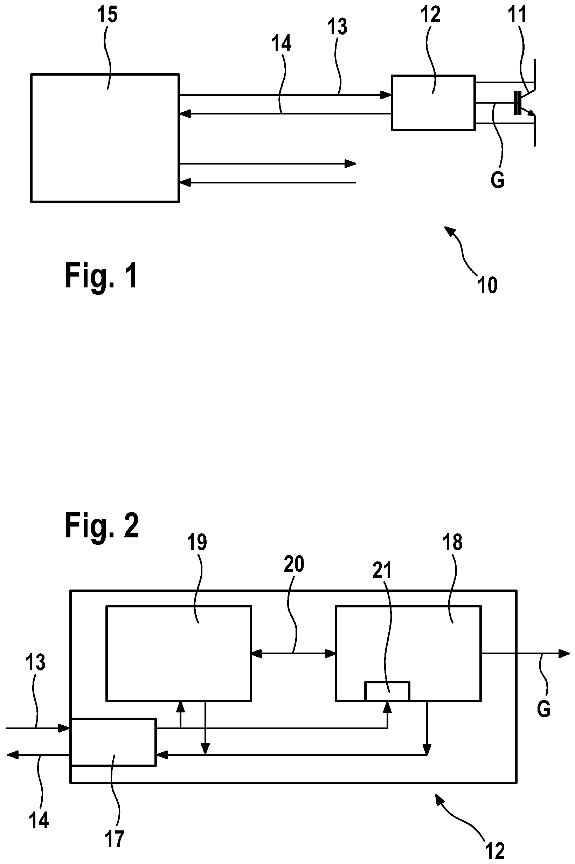

In der Figur 1 ist eine elektrische Schaltung 10 dargestellt, bei der ein elektrisches Leistungshalbleiter-Bauelement 11 von einer Endstufe 12 angesteuert wird. Bei dem Leistungshalbleiter-Bauelement 11 kann es sich um einen IGBT (IGBT = insulated gate bipolar transistor) oder um einen GTO-Thyristor (GTO = gate turn off) oder dergleichen handeln. Beispielhaft wird in der Figur 1 das Gate G des Leistungshalbleiter-Bauelements 11 von der Endstufe beaufschlagt und es sind weiterhin der Kollektor und der Emitter mit der Endstufe 12 verbunden. Es versteht sich, dass diese Ansteuerung auch andersartig ausgebildet sein kann.

Die Endstufe 12 ist ihrerseits über zwei Lichtwellenleiter 13, 14 mit einer Steuerung 15 verbunden. Die beiden Lichtwellenleiter 13, 14 sind dabei dazu vorgesehen, Signale in entgegengesetzte Richtungen zu übertragen. Es versteht sich, dass anstelle der Lichtwellenleiter 13, 14 auch andere potentialtrennende Übertragungsmedien oder Übertragungsarten denkbar sind, beispielsweise über Optokoppler oder über magnetische Übertrager oder mittels drahtloser Übertragungen oder dergleichen. Ebenfalls ist es gegebenenfalls möglich, die elektrischen Signale in beiden Übertragungsrichtungen über ein einziges Übertragungsmedium zu versenden und zu empfangen.

Wie dies in der Figur 1 angedeutet ist, kann die Steuerung 15 dazu vorgesehen sein, über weitere Lichtwellenleiter mit weiteren Endstufen und damit mit weiteren Leistungshalbleiter-Bauelementen verbunden zu sein.

Nachfolgend wird die Funktionsweise der Schaltung 10 der Figur 1 jedoch nur anhand eines einzigen Leistungshalbleiter-Bauelements erläutert. Es versteht sich, dass diese Funktionsweise auch auf eine Mehrzahl von Leistungshalbleiter-Bauelementen mit zugehörigen Endstufen angewendet werden kann.

In der Figur 2 ist die Endstufe 12 näher dargestellt. Die Endstufe 12 weist einen Sender/Empfänger 17 auf, an den die beiden Lichtwellenleiter 13, 14 angeschlossen sind, und der dazu vorgesehen ist, über den Lichtwellenleiter 13 ankommende Lichtsignale zu empfangen und auf dem Lichtwellenleiter 14 Lichtsignale zu versenden.

Der Sender/Empfänger 17 ist mit einer programmierbaren Logik 18 und mit einem Prozessor 19 verbunden. In der Figur 2 sind diese Verbindungen beispielhaft als einfache Hin- und Rückleitungen dargestellt. Es versteht sich, dass insoweit auch andere Verbindungsmöglichkeiten denkbar sind, beispielsweise parallele oder serielle Busstrukturen oder dergleichen.

Die Logik 18 ist mit einem Ausgang versehen, mit dem das Gate G des Leistungshalbleiter-Bauelements 11 angesteuert wird. Weiterhin sind die Logik 18 und der Prozessor 19 über eine bidirektionale Leitung 20 miteinander verbunden. Es versteht sich, dass es sich bei dieser Leitung 20 um jegliche Art einer Verbindung handeln kann, insbesondere um eine parallele oder serielle Busstruktur.

Bei der Logik 18 kann es sich beispielsweise um einen integrierten Schaltkreis handeln, in den eine logische Schaltung programmiert werden kann, also insbesondere um ein sogenanntes FPGA (FPGA = field programmable gate array). Alternativ kann es sich um ein sogenanntes CPLD (CPLD = complex programmable logic device) oder eine ähnliche integrierte Schaltung handeln. In jedem Fall ist es möglich, die Logik 18 mit Hilfe von Programmiersignalen zu programmieren. Mit Hilfe der Programmiersignale kann der Logik 18 eine bestimmte Funktionsweise vorgegeben werden. Diese Funktionsweise der Logik 18 definiert dabei die Art und Weise der Ansteuerung des Gates G des Leistungshalbleiter-Bauelements 11 durch die Endstufe 12. Beispielsweise legt die Programmierung den zeitlichen Ablauf des Ein- oder Ausschaltens des Leistungshalbleiter-Bauelements 11 fest.

Bei dem Prozessor 19 kann es sich um einen üblichen Mikroprozessor oder Signalprozessor oder dergleichen handeln.

Im Normalbetrieb der Schaltung 10 werden Ansteuersignale von der Steuerung 15 über den Lichtwellenleiter 13 an die Endstufe 12 gesendet. Diese Ansteuersignale werden auch als "firing pulses FP" bezeichnet. Die Ansteuersignale werden von dem Sender/Empfänger 17 der Endstufe 12 empfangen und von der Logik 18 verarbeitet. Von der Logik 18 wird dann das Leistungshalbleiter-Bauelement 11 in Abhängigkeit von den einzelnen Ansteuersignalen über sein Gate G leitend oder sperrend bzw. ein- oder ausgeschaltet.

Bei den Ansteuersignalen handelt es sich üblicherweise um definierte Signale mit vorgegebenen Impulsdauern und Amplituden. Anhand dieser Vorgaben kann die Logik 18 die Ansteuersignale erkennen und von anderen Signalen unterscheiden. Hierzu kann in der Logik 18 ein vorgeschaltetes Filter 21 vorhanden sein, von dem nur die Ansteuersignale zur weiteren Verarbeitung weitergegeben werden. Beispielsweise ist es möglich, dass die Ansteuersignale eine längere Impulsdauer aufweisen, und dass das Filter 21 andere Signale mit kurzen Signaldauern nicht durchlässt.

Über die Verbindung zu dem Kollektor und dem Emitter des Leistungshalbleiter-Bauelements 11 kann die Endstufe 12 in nicht-dargestellter Weise die Schalthandlungen des Leistungshalbleiter-Bauelements 11 erkennen. In Abhängigkeit davon kann der Sender/Empfänger 17 der Endstufe 12 einen sogenannten "indication pulse IP" über den Lichtwellenleiter 14 an die Steuerung 15 senden. Anhand des "indication pulse IP" kann die Steuerung 15 auf die Funktionsfähigkeit bzw. eine Fehlfunktion des Leistungshalbleiter-Bauelements 11 schließen.

Im Normalbetrieb der Schaltung 10 werden die Ansteuersignale auch von dem Prozessor 19 empfangen, jedoch nicht weiter verarbeitet.

In einem Programmierbetrieb der Schaltung 10 werden von der Steuerung 10 Programmiersignale über den Lichtwellenleiter 13 an die Endstufe 12 gesendet. Die Programmiersignale werden von dem Sender/Empfänger 17 empfangen und an die Logik 18 und den Prozessor 19 weitergeleitet.

Die Programmiersignale unterscheiden sich insbesondere hinsichtlich ihrer Signaldauer und/oder Amplitude von den Ansteuersignalen. Beispielsweise ist es möglich, dass die Programmiersignale eine kürzere Signaldauer aufweisen. Die Programmiersignale werden daher von dem Filter 21 herausgefiltert und nicht an die Logik 18 weitergegeben.

Die Programmiersignale werden somit von der Logik 18 nicht zum Zwecke der Ansteuerung des Leistungshalbleiter-Bauelements 11 verarbeitet. Die Programmiersignale werden jedoch von dem Prozessor 19 verarbeitet.

Es ist möglich, dass der Prozessor 19 die von dem Steuergerät übertragenen Programmiersignale als solche erkennen und weiterverarbeiten kann. Alternativ ist es möglich, dass die gesendeten Programmiersignale an ihrem zeitlichen Beginn eine Start-Kodierung enthalten, mit der dem Prozessor 19 mitgeteilt wird, dass nunmehr die eigentlichen Programmiersignale folgen.

Nachdem der Prozessor 19 den Empfang von Programmiersignalen erkannt hat, wird die Logik 18 von dem Prozessor 19 über die Leitung 20 von dem Normalbetrieb in den Programmierbetrieb umgeschaltet. Dies bedeutet, dass das Leistungshalbleiter-Bauelement 11 nicht mehr von der Logik 18 angesteuert wird und auch keine sonstigen, auf das Leistungshalbleiter-Bauelement 11 bezogenen Funktionen mehr von der Logik 18 ausgeführt werden.

Danach werden die empfangenen Programmiersignale von dem Prozessor 19 dahingehend aufbereitet, dass die Logik 18 nunmehr mit diesen Programmiersignalen programmiert werden kann.

Beispielsweise ist es möglich, dass die Programmiersignale von dem Prozessor 19 derart aufbereitet werden, dass sie danach dem sogenannten JTAG-Protokoll (JTAG = joint test action group) entsprechen. Dabei handelt es sich um ein standardisiertes Protokoll zum Programmieren von integrierten Schaltungen. Insbesondere können die bereits erwähnten FPGAs oder CPLDs mit Hilfe des JTAG-Protokolls programmiert werden.

Die aufbereiteten Programmiersignale werden von dem Prozessor 19 über die Leitung 20 an die Logik 18 weitergegeben. Gegebenenfalls werden die empfangenen Programmiersignale von der Logik 18 über dieselbe Leitung 20 an den Prozessor 19 quittiert. Auf diese Weise wird der Logik 18 in Abhängigkeit von den Programmiersignalen eine neue Funktionsweise vorgegeben. Es erfolgt also eine Programmierung der Logik 18 über die Leitung 20 anhand der aufbereiteten Programmiersignale.

Das Ende der Programmierung kann entweder durch eine Beendigung der Übertragung der Programmiersignale oder durch eine zeitlich zuletzt von dem Steuergerät 15 übertragene Ende-Kodierung dem Prozessor 19 mitgeteilt werden. Nachdem die Programmierung der Logik 18 beendet ist, wird die Logik 18 von dem Prozessor 19 über die Leitung 20 von dem Programmierbetrieb wieder in den Normalbetrieb zurückgeschaltet. Zusätzlich kann das Ende des Programmierbetriebs bzw. die Rückschaltung in den Normalbetrieb von dem Prozessor 19 über den Sender/Empfänger 17 an die Steuerung 15 gemeldet werden. Gegebenenfalls ist es möglich, dass für den weiteren Betrieb der Schaltung 10 zusätzlich ein Reset-Signal oder dergleichen von der Steuerung 15 erforderlich ist.

Mit dem vorstehend erläuterten Verfahren kann - sofern erforderlich - die Logik 18 der Endstufe 12 neu programmiert werden. Insbesondere ist es auf diese Weise möglich, ein sogenanntes Programm-Update der Logik 18 durchzuführen. Es versteht sich, dass in entsprechender Weise auch weitere Endstufen von Leistungshalbleiter-Bauelementen programmiert werden können. Insgesamt ist es damit beispielsweise möglich, alle Endstufen der Leistungshalbleiter-Bauelemente einer Stromrichterschaltung zu programmieren.

Ist die Steuerung 15 dazu vorgesehen, alle Endstufen der Leistungshalbleiter-Bauelemente einer gesamten Stromrichterschaltung zu beeinflussen, so können von dieser Steuerung 15 auch alle Endstufen programmiert werden. Ist die Steuerung 15 zusätzlich dazu vorgesehen, mit einer sogenannten Fernwartung zusammenzuarbeiten, so ist es möglich, die Endstufen der Stromrichterschaltung über diese Fernwartung zu programmieren.

## Patentansprüche

1. Verfahren zum Betreiben eines elektrischen Leistungshalbleiter-Bauelements (11), wobei dem Leistungshalbleiter-Bauelement (11) eine Endstufe (12) mit einer programmierbaren Logik (18) zugeordnet ist, wobei der Endstufe (12) Ansteuersignale für das Leistungshalbleiter-Bauelement (11) gesendet werden, wobei das Leistungshalbleiter-Bauelement (11) von der Endstufe (12) in Abhängigkeit von den Ansteuersignalen beeinflusst wird, und wobei die Art und Weise der Beeinflussung des Leistungshalbleiter-Bauelements (11) durch die Programmierung der Logik (18) festlegt ist, wobei der Endstufe (12) Programmiersignale gesendet werden können, wobei die Programmiersignale von einem Prozessor (19) der Endstufe (12) verarbeitet werden können, und wobei die Programmierung der Logik (18) von dem Prozessor (19) in Abhängigkeit von den Programmiersignalen verändert werden kann, **dadurch gekennzeichnet, dass** Lichtwellenleiter (13, 14) vorhanden sind, dass die Ansteuersignale und die Programmiersignale über denselben Lichtwellenleiter (13) gesendet werden, und dass die Ansteuersignale im Normalbetrieb gesendet werden und die Programmiersignale in einem Programmierbetrieb gesendet werden.

2. Verfahren nach Anspruch 1, wobei die Programmiersignale von dem Prozessor (19) insbesondere dahingehend aufbereitet werden, dass die aufbereiteten Programmiersignale dem sogenannten JTAG-Protokoll entsprechen.

3. Verfahren nach einem der vorstehenden Ansprüche, wobei die Logik (18) von dem Prozessor (19) in einen Programmierbetrieb umgeschaltet wird, in dem das Leistungshalbleiter-Bauelement (11) nicht mehr in Abhängigkeit von den Ansteuersignalen beeinflusst wird.

4. Verfahren nach Anspruch 3, wobei im Programmierbetrieb die Programmierung der Logik (18) verändert wird.

5. Verfahren nach Anspruch 3 oder 4, wobei im Rahmen der Programmiersignale eine Start-Kodierung und/oder eine Ende-Kodierung gesendet werden, die den Beginn und/oder das Ende des Programmierbetriebs anzeigen.

6. Verfahren nach einem der vorstehenden Ansprüche, wobei die Programmiersignale von einer Steuerung (15) versendet werden.

7. Verfahren nach einem der vorstehenden Ansprüche, wobei die Programmiersignale von der Logik (18) nicht für die Ansteuerung des Leistungshalbleiter-Bauelements (11) verarbeitet werden.

8. Elektrische Schaltung (10) zum Betreiben eines elektrischen Leistungshalbleiter-Bauelements (11), wobei dem Leistungshalbleiter-Bauelement (11) eine Endstufe (12) mit einer programmierbaren Logik (18) zugeordnet ist, wobei der Endstufe (12) Ansteuersignale für das Leistungshalbleiter-Bauelement (11) zusendbar sind, wobei das Leistungshalbleiter-Bauelement (11) von der Logik (18) in Abhängigkeit von den Ansteuersignalen beeinflussbar ist, und wobei die Art und Weise der Beeinflussung des Leistungshalbleiter-Bauelements (11) durch die Programmierung der Logik (18) festlegt ist, wobei der Endstufe (12) Programmiersignale zusendbar sind, wobei die Programmiersignale von einem Prozessor (19) der Endstufe (12) verarbeitbar sind, und wobei die Programmierung der Logik (18) von dem Prozessor (19) in Abhängigkeit von den Programmiersignalen veränderbar ist, **dadurch gekennzeichnet, dass** Lichtwellenleiter (13, 14) vorhanden sind, dass die Ansteuersignale und die Programmiersignale über denselben Lichtwellenleiter (13) an die Endstufe (12) zusendbar sind, und dass die Ansteuersignale im Normalbetrieb zusendbar sind und die Programmiersignale in einem Programmierbetrieb zusendbar sind.

9. Schaltung (10) nach Anspruch 8, wobei die Logik (18) derart ausgebildet ist, dass deren Programmierung durch die aufbereiteten Programmiersignale veränderbar ist.

10. Schaltung (10) nach Anspruch 8 oder 9, wobei es sich bei der Logik (18) um ein FPGA oder ein CPLD handelt.

11. Schaltung (10) nach einem der Ansprüche 8 bis 10, wobei die Programmiersignale von einem der Logik (18) vorgeschalteten Filter (21) filterbar sind.

12. Schaltung (10) nach einem der Ansprüche 8 bis 11, wobei eine Steuerung (15) zur Übertragung der Programmiersignale an die Endstufe (12) vorhanden ist.

13. Stromrichterschaltung mit einer Schaltung (10) nach einem der Ansprüche 8 bis 12, wobei die Schaltung (10) eine Mehrzahl von Leistungshalbleiter-Bauelementen (11) mit zugeordneten Endstufen (12) aufweist.

14. Stromrichterschaltung nach Anspruch 13, wobei die Schaltung (10) eine insbesondere fernwartbare Steuerung (15) aufweist.

## Claims

1. Method for operating an electrical power semiconductor element (11), wherein an end stage (12) with a programmable logic (18) is assigned to the power semiconductor element (11), wherein actuation signals for the power semiconductor element (11) are sent to the end stage (12), wherein the power semiconductor element (11) is influenced by the end stage (12) as a function of the actuation signals, and wherein the manner of influencing the power semiconductor element (11) is established by the programming of the logic (18), wherein programming signals may be sent to the end stage (12), wherein the programming signals can be processed by a processor (19) of the end stage (12), and wherein the programming of the logic (18) can be changed by the processor (19) depending on the programming signals, **characterised in that** light waveguides (13, 14) are present, that the actuating signals and the programming signals are sent via said light waveguides (13), and that the actuation signals are sent in normal operating mode and the programming signals are sent in a programming mode.

2. Method according to claim 1, wherein the programming signals are in particular treated by the processor (19) such that the treated programming signals correspond to the so-called JTAG protocol.

3. Method according to one of the preceding claims, wherein the logic (18) is switched by the processor (19) into programming mode, in that the power semiconductor element (11) is no longer influenced as a function of the actuation signals.

4. Method according to claim 3, wherein the programming of the logic (18) is changed in programming mode.

5. Method according to claim 3 or 4, wherein as part of the programming signals, a start coding and/or an end coding are sent which indicate the start and/or end of programming mode.

6. Method according to any of the preceding claims, wherein the programming signals are sent by a controller (15).

7. Method according to any of the preceding claims, wherein the programming signals are processed by the logic (18) so as not to actuate the power semiconductor element (11).

8. Electrical circuit (10) for operating an electrical power semiconductor element (11), wherein an end stage (12) with a programmable logic (18) is assigned to the power semiconductor element (11), wherein actuation signals for the power semiconductor element (11) can be sent to the end stage (12), wherein the power semiconductor element (11) can be influenced by the logic (18) as a function of the actuation signals, and wherein the manner of influencing the power semiconductor element (11) is established by the programming of the logic (18), wherein programming signals can be sent to the end stage (12), wherein the programming signals can be processed by a processor (19) of the end stage (12), and wherein the programming of the logic (18) can be changed by the processor (19) depending on the programming signals, **characterised in that** light waveguides (13, 14) are present, that the actuating signals and the programming signals are sent via said light waveguides (13) to the end stage (12), and that the actuation signals can be sent in normal operating mode and the programming signals can be sent in a programming mode.

9. Circuit (10) according to claim 8, wherein the logic (18) is configured such that its programming can be changed by the treated programming signals.

10. Circuit (10) according to claim 8 or 9, wherein the logic (18) is an FGPA or a CPLD.

11. Circuit (10) according to any of claims 8 to 10, wherein the programming signals can be filtered by a filter (21) connected upstream of the logic (18).

12. Circuit (10) according to any of claims 8 to 11, wherein a controller (15) is present for sending the programming signals to the end stage (12).

13. Power converter circuit with a circuit (10) according to any of claims 8 to 12, wherein the circuit (10) comprises a plurality of power semiconductor elements (11) with assigned end stages (12).

14. Power converter circuit according to claim 13, wherein the circuit (10) comprises a controller (15) which in particular can be maintained remotely.

## Revendications

1. Procédé pour faire fonctionner un composant semi-conducteur de puissance (11) électrique, selon lequel un étage de sortie (12), doté d'une logique programmable (18), est associé au composant semi-conducteur de puissance (11), des signaux de commande pour le composant semi-conducteur de puissance (11) sont envoyés à l'étage de sortie (12), le composant semi-conducteur de puissance (11) est influencé par l'étage de sortie (12) en fonction des signaux de commande, et la manière dont le composant semi-conducteur de puissance (11) est influencé est déterminée par la programmation de la logique (18), des signaux de programmation peuvent être envoyés à l'étage de sortie (12), les signaux de programmation peuvent être traités par un processeur (19) de l'étage de sortie (12), et la programmation de la logique (18) peut être modifiée par le processeur (19) en fonction des signaux de programmation, **caractérisé en ce qu'**il est prévu des guides d'ondes optiques (13, 14), **en ce que** les signaux de commande et les signaux de programmation sont transmis sur le même guide d'ondes optiques (13), et **en ce que** les signaux de commande sont émis en mode normal et les signaux de programmation sont émis en mode programmation.

2. Procédé selon la revendication 1, selon lequel les signaux de programmation sont traités par le processeur (19), notamment de telle sorte que les signaux de programmation traités correspondent au protocole « JTAG ».

3. Procédé selon l'une des revendications précédentes, selon lequel la logique (18) est commutée par le processeur (19) à un mode de programmation dans lequel le composant semi-conducteur de puissance (11) n'est plus influencé en fonction des signaux de commande.

4. Procédé selon la revendication 3, selon lequel la programmation de la logique (18) est modifiée en mode programmation.

5. Procédé selon la revendication 3 ou 4, selon lequel, dans le cadre des signaux de programmation, un codage de début et/ou un codage de fin indiquant le début et/ou la fin du mode de programmation est transmis.

6. Procédé selon l'une des revendications précédentes, selon lequel les signaux de programmation sont transmis par un dispositif de commande (15).

7. Procédé selon l'une des opérations précédentes, selon lequel les signaux de programmation ne sont pas traités par la logique (18) pour commander le dispositif semi-conducteur de puissance (11).

8. Circuit électrique (10) destiné à faire fonctionner un composant semi-conducteur de puissance (11) électrique, dans lequel un étage de sortie (12), doté d'une logique programmable (18), est associé au composant semi-conducteur de puissance (11), des signaux de commande pour le composant semi-conducteur de puissance (11) peuvent être envoyés à l'étage de sortie (12), le composant semi-conducteur de puissance (11) peut être influencé par la logique (18) en fonction des signaux de commande, et la manière dont le composant semi-conducteur de puissance (11) est influencé est déterminée par la programmation de la logique (18), des signaux de programmation peuvent être envoyés à l'étage de sortie (12), les signaux de programmation peuvent être traités par un processeur (19) de l'étage de sortie (12), et la programmation de la logique (18) peut être modifiée par le processeur (19) en fonction des signaux de programmation, **caractérisé en ce qu'**il est prévu des guides d'ondes optiques (13, 14), **en ce que** les signaux de commande et les signaux de programmation peuvent être transmis à l'étage de sortie (12) par l'intermédiaire du même guide d'ondes optiques (13), et **en ce que** les signaux de commande peuvent être transmis en mode normal et les signaux de programmation peuvent être transmis en mode programmation.

9. Circuit (10) selon la revendication 8, dans lequel la logique (18) est conçue de telle sorte que sa programmation puisse être modifiée par les signaux de programmation traités.

10. Circuit (10) selon la revendication 8 ou 9, dans lequel la logique (18) est un circuit FPGA ou un circuit CPLD.

11. Circuit (10) selon l'une des revendications 8 à 10, dans lequel les signaux de programmation peuvent être filtrés par un filtre (21) placé en amont de la logique (18).

12. Circuit (10) selon l'une des revendications 8 à 11, dans lequel il est prévu un dispositif de commande (15) destiné à transmettre les signaux de programmation à l'étage de sortie (12).

13. Montage convertisseur de courant comportant un circuit (10) selon l'une des revendications 8 à 12, dans lequel le circuit (10) présente une pluralité de composants semi-conducteurs de puissance (11) avec des étages de sortie (12) associés.

14. Montage convertisseur de courant selon la revendication 13, dans lequel le circuit (10) présente un dispositif de commande (15) qui peut notamment faire l'objet d'une télémaintenance.
